## Europäisches Patentamt

(19) **European Patent Office**

**Office européen des brevets**

(11) Numéro de publication: **0 079 352 B1**

(12) **FASCICULE DE BREVET EUROPEEN**

(45) Date de publication du fascicule du brevet:
27.11.85

(51) Int. Cl.⁴: **H 03 F 3/24**

(21) Numéro de dépôt: 82901514.8

(22) Date de dépôt: 18.05.82

(86) Numéro de dépôt international:
**PCT/FR 82/00083**

(87) Numéro de publication internationale:
**WO 82/04166 (25.11.82 Gazette 82/28)**

(54) **AMPLIFICATEUR A TRANSISTOR FONCTIONNANT EN HYPERFREQUENCE EN REGIME IMPULSIONNEL.**

(30) Priorité: 22.05.81 FR 8110255

(43) Date de publication de la demande:
25.05.83 Bulletin 83/21

(45) Mention de la délivrance du brevet:
27.11.85 Bulletin 85/48

(84) Etats contractants désignés:
**DE FR GB**

(56) Documents cités:
**FR - A - 2 250 237**
**US - A - 2 906 891**
**US - A - 3 562 557**
**US - A - 3 919 656**

IEEE Journal of Solid State Circuits, volume SC-16, no. 2, avril 1981 (New York, US) J. Ebert et al. "Class E high-efficiency tuned power oscillator" pages 62-66, voir figures 1-2; pages 63-63, les paragraphes "Introduction" et "Information about class E amplifier"
Motorola Semiconductor Products Application Note AN-217, 4 septembre 1967 Motorola Phoenix, (Arizona. US) D.L. Wollesen "UHF transmission-line power-amplifier designed with Smith-chart techniques" voir figures; pages 2-3, le paragraphe "450 MHz power amplifier"

(73) Titulaire: **THOMSON-CSF, 173, Boulevard Haussmann, F-75379 Paris Cedex 08 (FR)**

(72) Inventeur: **LORIEUX, Roland, 9, rue des Econdeaux, F-93800 Epinay sur Seine (FR)**

(74) Mandataire: **Benoît, Monique et al, THOMSON-CSF SCPI 173, Bld Haussmann, F-75379 Paris Cedex 08 (FR)**

## Description

La présente invention est relative à un amplificateur à transistor fonctionnant en hyperfréquence et plus particulièrement à un amplificateur fonctionnant en impulsions. Dans ce cas et principalement quand le transistor est à forte puissance, le temps d'établissement du courant n'est pas négligeable et dans certains applications, relatives au radar, l'allongement du temps de montée des impulsions de sortie de l'amplificateur entraîne des erreurs dans les mesures de distance, en particulier.

Un état de l'art d'un amplificateur à transistor fonctionnant en haute fréquence peut être constitué par le brevet américain 3 919 656 déposé le 23 avril 1973.

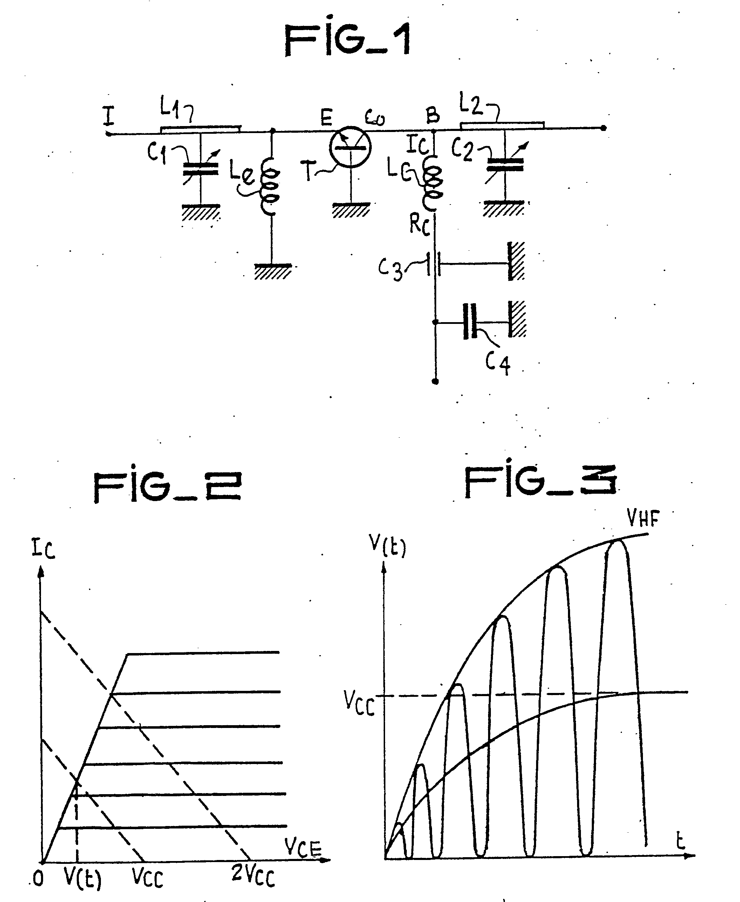

La figure 1 de la présente demande représente un amplificateur à transistor fonctionnant en haute fréquence semblable à celui du brevet américain cité, à la seule différence que le transistor T est monté en base à la masse et non en émetteur commun; il fonctionne en classe B c'est-à-dire sans tension de polarisation. Son émetteur E est connecté à l'entrée du dispositif I par un ensemble L1 C1, self, capacité et une self L dite d'entrée est placée en parallèle sur l'émetteur du transistor T. Le collecteur du transistor est connecté à la sortie du dispositif par un ensemble L2 C2. L'alimentation se fait à partir d'une source VCC qui applique un courant Ic au collecteur du transistor à travers une self Lc après déblocage par l'impulsion d'entrée. Une capacité chimique de forte valeur C4 sert de réservoir d'énergie au moment de l'appel du courant Ic. La capacité C3 est une capacité de découplage pour la haute fréquence.

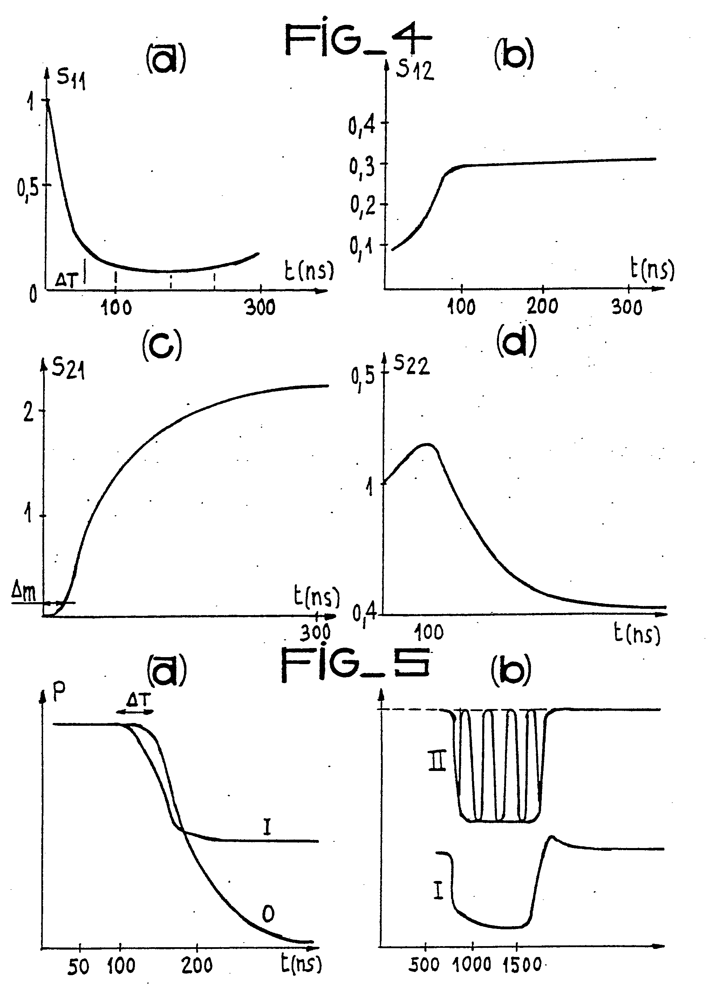

Utilisé avec des impulsions, un tel montage présente des inconvénients en régime transitoire. Dans ce cas en effet la mise en conduction brutale du transistor débloqué par l'apparition de l'impulsion d'entrée, provoque un fort appel de courant à travers la self L1 connectée entre l'entrée de l'amplificateur et l'émetteur du transistor T. Le courant d'alimentation varie alors suivant une loi exponentielle dont la constante de temps est proportionnelle aux composantes selfiques incluses dans le circuit d'alimentation du transistor en courant continu Lc et Le. La figure 2 montre l'évolution du courant Ic d'alimentation en fonction de la tension VCE entre collecteur et émetteur. La figure 3 montre l'évolution de la tension haute fréquence en sortie en fonction du temps à partir de l'instant d'application de l'impulsion d'entrée. On constate bien que la tension appliquée au collecteur croît de façon progressive avec une asymptote constituée par la valeur de la source d'alimentation VCC et que l'enveloppe des impulsions de tension haute fréquence a une forme exponentielle, autrement dit que les fronts de montée ont une pente inférieure à celle des fronts de montée des impulsions d'entrée. L'idéal serait que la tension VCC soit atteinte dans un temps minimal.

Pour remédier à cet inconvénient, on a tenté de diminuer les selfs Le et Lc, mais on est limité dans cette action par les impédances d'entrée et de sortie du transistor qui imposent une valeur au-dessous de laquelle les impédances Le et Lc ne peuvent baisser pour que les signaux haute fréquence ne soient pas court-circuités. Or, l'effet de ces selfs Le et Lc s'avère d'autant plus marqué que la valeur des crêtes de courant HF est grande, cas des transistors de puissance. Il apparaît de la sorte que le temps d'établissement du courant dans un transistor de puissance ne peut être réduit suffisamment lorsque l'on diminue les selfs Le et Lc.

Un autre phénomène lié au précédent est dû au temps de mise en conduction du transistor pour lequel l'apparition de la puissance de sortie nominale ne peut commencer que lorsque le courant collecteur a atteint sa valeur moyenne soit

$$Ic = VCC/Rc,$$

VCC étant la tension d'alimentation et Rc la résistance de charge.

En étudiant les paramètres en S du transistor que l'on rappelle ci-dessous, on peut se rendre compte des limites de son fonctionnement:
— le paramètre S11 représente le coefficient de réflexion d'entrée de l'amplificateur, — le paramètre S22 représente le coefficient de réflexion en sortie, — les paramètres S21 et S12 représentent les coefficients de transmission, respectivement dans le sens entrée vers sortie et sortie vers entrée; le paramètre S21 est le gain au transistor du sens usuel du terme.

Les figures 4a à 4d montrent une représentation graphique de ces différents coefficients. On constate en examinant la courbe S11 = f(t), figure 4a, que l'énergie réfléchie reste importante pendant les cinquante premières nanosecondes, c'est-à-dire que le transistor ne se débloque qu'après un certain laps de temps. L'énergie transmise demeure faible et le gain est inférieur à l'unité, figure 4c. L'adaptation ainsi que la puissance transmises deviennent correctes au bout d'environ 200 ns.

La figure 5a qui représente la puissance transmise en fonction du temps montre (courbe I) que la puissance est appliquée à l'entrée bien avant que la puissance de sortie se manifeste (courbe O), le temps $\triangle$T étant le temps de déblocage du transistor. La figure 5b montre la forme de l'impulsion d'entrée (courbe I), le transistor absorbe du courant avant que la puissance de sortie n'apparaisse (courbe II).

Ainsi qu'il a été dit plus haut, la cause principale des inconvénients observés réside dans les parties selfiques des circuits d'alimentation qui ne peuvent jamais être tout à fait annulées. On a essayé de réduire en partie ce défaut en plaçant une capacité chimique C4 de forte valeur en parallèle sur l'alimentation juste avant la self de sollecteur Lc. Cette capacité est repérée C4 sur la figure 1 et effectivement, elle masque les composantes inductives et résistives situées en amont, c'est-à-dire côté alimentation, mais étant de grande valeur elle assure également la fourniture d'énergie du transistor pendant les périodes de circulation de courant intense à condition toutefois que son impédance interne soit négligeable, ce qui s'avère difficilement réalisable dans la pratique.

Un but de l'invention est de prévoir des moyens qui permettent à l'amplificateur à transistor à haute fréquence de fonctionner en régime impulsionnel sans présenter les inconvénients qui ont été rappelés ci-dessus.

L'amplificateur à transistor fonctionnant en hyperfréquence en régime impulsionnel comporte:

— au moins un transistor monté en base à la masse et recevant des impulsions dites d'entrée,

— une self dite d'entrée placée en parallèle sur la base du transistor,

— une source de tension d'alimentation appliquant un courant au collecteur du transistor à travers une self dite de collecteur,

— une capacité connectée en parallèle sur la source,

— une capacité de découplage connectée entre la source et la self de collecteur,

caractérisé en ce qu'il comporte de plus une capacité entre l'émetteur et le collecteur connectée du transistor, chargée par la source de tension d'alimentation et destinée à emmagasiner de l'énergie pendant les périodes de repos du transistor et à la restituer au début de chaque impulsion d'entrée avec une constante de temps la plus réduite possible.

L'invention est ainsi caractérisée en ce qu'elle comprend des moyens pour fornir au transistor de l'amplificateur le courant d'alimentation dès le début de l'impulsion d'entrée en diminuant la constante de temps de mise en conduction et le délai nécessaire à l'atteinte de la saturation, ces moyens qui restituent l'énergie du transistor étant placés le plus près possible de ce dernier et minimisant l'effet des selfs série. L'effet des selfs série tend à s'opposer naturellement au passage du courant, mais les moyens suivant l'invention sont tels qu'ils ne provoquent pas de court-circuit de la composante haute fréquence.

Suivant une réalisation préférentielle de l'invention, ces moyens sont constitués par une capacité capable d'emmagasiner de l'énergie pendant les périodes de repos et la restituer au début de l'impulsion d'entrée avec une constante de temps la plus réduite possible.

D'autres avantages et caractéristiques de l'invention apparaîtront au cours de la description qui suit d'un exemple de réalisation donné à l'aide, outre des figures 1 à 5, ressortissant à l'art antérieur, des figures 6, 7, 8, 9 et 10 qui représentent:

la figure 6, les différents montages possibles de la capacité C aux bornes d'un transistor;

la figure 7, les variations des coefficients en S du transistor dans le montage suivant l'invention;

la figure 8, la courbe enveloppe des impulsions HF de sortie dans le montage suivant l'invention;

la figure 9, l'allure des impulsions de sortie pour deux valeurs de la capacité C;

la figure 10, le montage des moyens capacitifs pour un amplificateur à deux transistors montés en push-pull.

Ainsi qu'il ressort de l'introduction à la présente description, l'invention a pour but de définir les moyens permettant d'utiliser dans de bonnes conditions, un amplificateur à transistor fonctionnant en impulsions en hyperfréquence et de puissance élevée, en régime transitoire. Ces moyens comme cela a été dit plus haut, doivent être capables de fournir au transistor amplificateur un courant d'alimentation dès que l'impulsion d'entrée lui a été appliquée, de façon que la constante des temps de mise en conduction du transistor soit diminuée et que la saturation soit atteinte le plus rapidement possible.

Ces moyens sont, ainsi que cela a été dit constitués de préférence par une capacité emmagasinant de l'énergie pendant les périodes de repos du transistor et la restituant dès le début de la période de conduction déclenchée par une impulsion d'entrée; la constante de temps de cette capacité doit être donc la plus faible possible lorsqu'elle se décharge. L'emplacement de cette capacité revêt une certaine importance, car il est nécessaire, comme cela a été vu, que l'effet des selfs série $L_c$-$L_e$ soit réduit le plus possible pour qu'elles ne puissent fournir une grande opposition au passage du courant, bien qu'elles ne doivent en aucun cas court-circuiter les composantes haute fréquence.

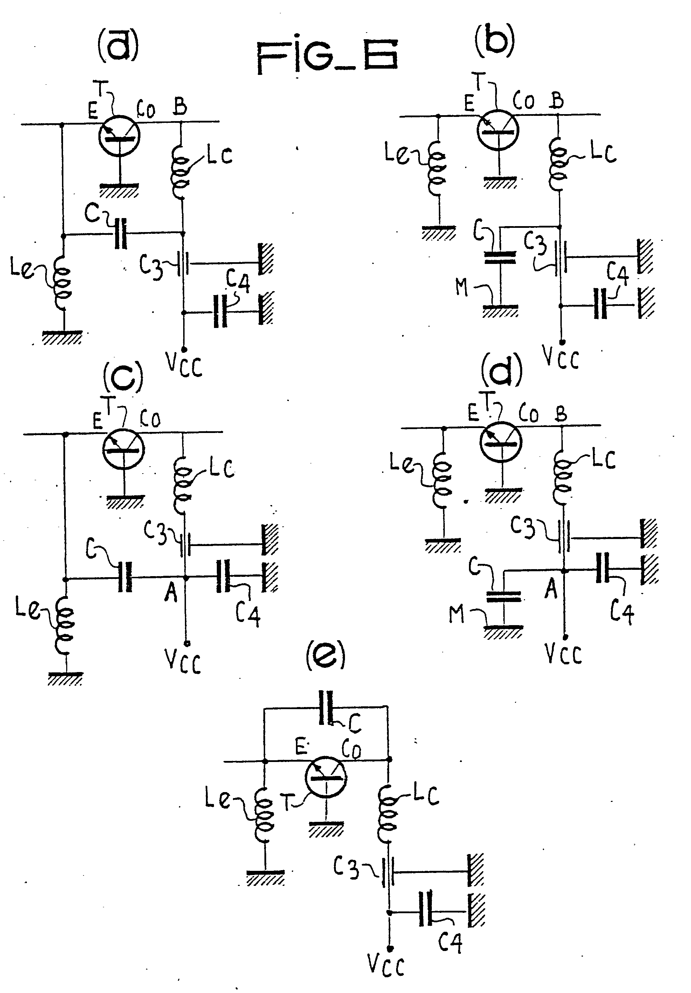

Les figures 6 qui reprennent partiellement la figure 1 montrent des emplacements possibles de la capacité C, pour qu'elle réalise les conditions permettant à l'amplificateur à transistor d'être utilisable et utilisé en régime transitoire.

Suivant la figure 6a, la capacité C est connectée entre le point de connexion de l'impédance d'entrée $L_e$ et le point commun de la self $L_c$ du collecteur et de la capacité de découplage C3. La mise en place de cette capacité C est relativement facile, elle diminue l'effet de la self de l'émetteur $L_c$ et élimine la self de collecteur $L_c$; la conduction du transistor est accélérée.

Suivant la figure 6b, la capacité C est connectée entre la masse M et le point commun de la self $L_c$ du collecteur et de la capacité de découplage C3. La mise en place de cette capacité C est facile; rapprochée du collecteur du transistor, cette capacité a pour effet de diminuer l'influence de la self série L, elle n'agit toutefois par sur la vitesse de conduction du transistor.

Suivant la figure 6c, la capacité C est connectée entre le point E de connexion de la self Le d'entrée et le point A commun aux capacités C3 et C4. Les effets de cet emplacement sont moins bons que ceux obtenus avec l'emplacement montré figure 6b car il y a plus de self série, et la mise en place est relativement difficile.

Suivant la figure 6d, la capacité C est connectée entre la masse M et le point A. Le montage est facile à réaliser mais les effets des selfs séries ne sont pas bien diminués.

Suivant la figure 6e, la capacité C est placée directement aux bornes du transistor entre l'émetteur et le collecteur et le plus près possible de lui, c'est-à-dire avec les connexions les plus courtes. Cet emplacement est certes le meilleur possible, toutefois la mise en place est difficile.

Pour ce qui concerne le fonctionnement du montage avec la capacité C montée suivant les représentations des figures 6, on rappellera ce qui suit: dans son fonctionnement normal, un transistor est débloqué par mise en conduction de sa jonction émetteur base au moment où la tension d'entrée apparaît. Cette conduction entraîne ensuite le déblocage de la jonction base-collecteur et provoque la circulation du courant dans l'espace collecteur-émetteur. Le fait que cette conduction se fasse en deux temps explique les retards constatés dans les montages de l'art antérieur.

Ces retards préjudiciables, comme cela a tété mentionné, doivent être éliminés ou tout au moins fortement diminués par le montage suivant l'invention.

De fait, la présence d'une capacité C entre émetteur et collecteur, présence préconisée par l'invention, a pour effet d'appliquer la tension de commande de déblocage du transistor, simultanément sur les deux jonctions et donc de débloquer simultanément les deux jonctions. Cette capacité C de la sorte accélère la mise en conduction du transistor.

De plus cette capacité C est chargée à la tension d'alimentation + VCC pendant les périodes de non conduction du transistor. Au moment du déblocage accéléré ainsi qu'il a été expliqué, cette capacité fournit instantanément du courant qui circule dans l'espace émetteur-collecteur devenu passant. Il est donc évident que par la présence de la capacité C, le point de fonctionnement est atteint beaucoup plus rapidement qu'avec les montages de l'art antérieur.

Les figures 7a à 7d présentent les courbes de variation des paramètres S qui ont été définis précédemment.

Il est clair que les effets constatés, avec le montage suivant l'invention sont nettement améliorés par rapport à ceux constatés à l'aide de figures 4. Par exemple, sur la figure 7a, on voit que le temps de déblocage $\triangle t$ du transistor est nettement réduit, c'est-à-dire que le coefficient de réflexion à l'entrée passe de la valeur 1 pour laquelle le transistor est bloqué à une valeur faible en quelques nanosecondes tandis que le gain, figure 7c, atteint sa valeur maximale au bout d'environ 50 nanosecondes, sans temps mort $\triangle m$, alors que suivant l'art antérieur il ne l'atteignait qu'en 300 nanosecondes (figure 4c). L'amélioration constatée pour le montage suivant l'invention est sensible dans un rapport de plus de 4. Cette rapidité dans le déblocage du transistor est visible également sur la courbe de la figure 7d.

Sur la figure 7b, représentant le paramètre S12, coefficient de transmission de la sortie vers l'entrée du transistor, on constate qu'il est très faible.

La valeur de la capacité C, pour que les résultats obtenus soient considérés comme bons, est comprise entre 0,1 et 5 µF.

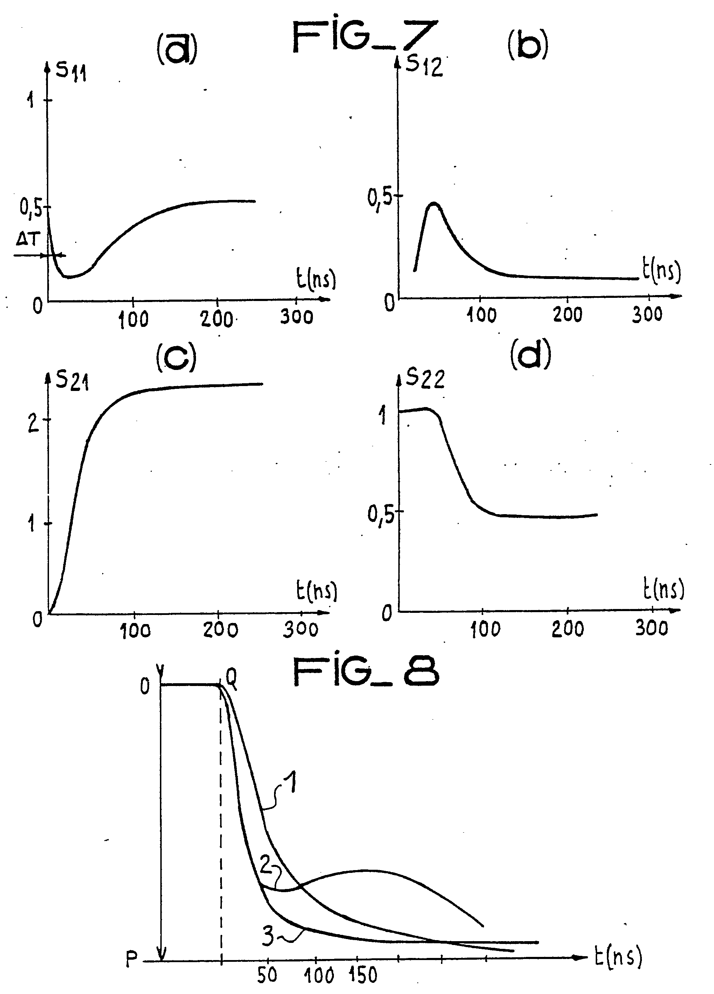

La figure 8 montre la courbe enveloppe des impulsions HF de sortie du transistor pour différentes valeurs de capacité, c'est-à-dire la puissance P en fonction du temps. Les courbes 1, 2 et 3 ont une partie commune, jusqu'au point Q où la puissance d'entrée est appliquée. La courbe 1 donnée lorsqu'il n'y a pas de capacité aux bornes du transistor dénote une montée en puissance lente par rapport à la courbe 2 où la montée en puissance est plus rapide au départ, mais se ralentit ensuite, ce phénomène étant dû au fait que la capacité à une valeur insuffisante de l'ordre de 0,1 µF par exemple; la courbe 3 obtenue pour une valeur de capacité C de l'ordre de 4,7 µF est proche de l'idéal. Montrée rapide de la puissance jusqu'au maximum.

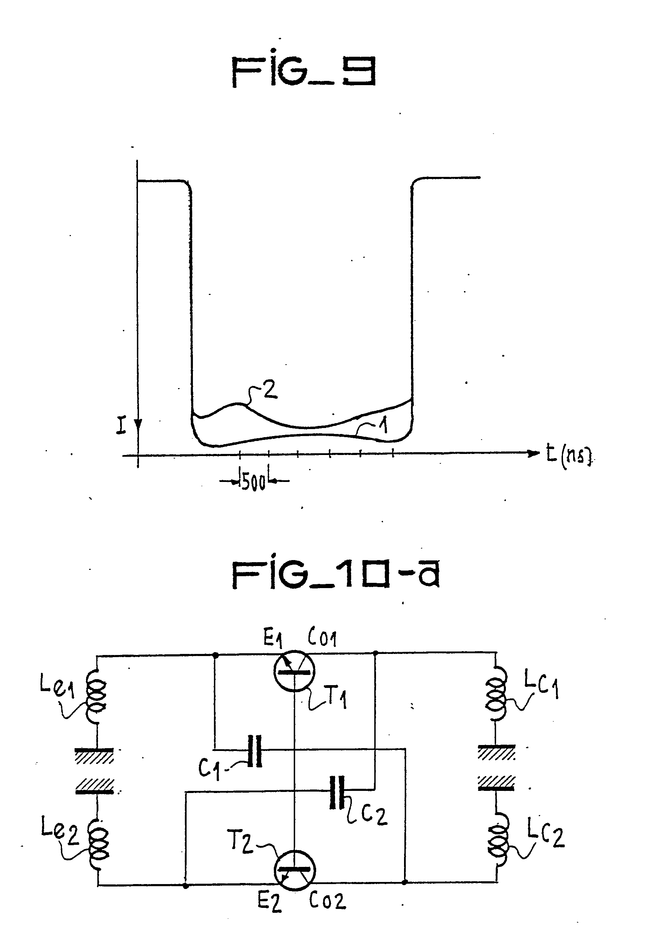

La figure 9 montre l'allure des impulsions de sortie, courbe 1 pour une capacité de 4,7 µF et courbe 2 pour une capacité de 1 µF. L'impulsion de sortie l'établit plus rapidement que l'impulsion 2 et sa valeur reste constante pendant toute la durée de son existence.

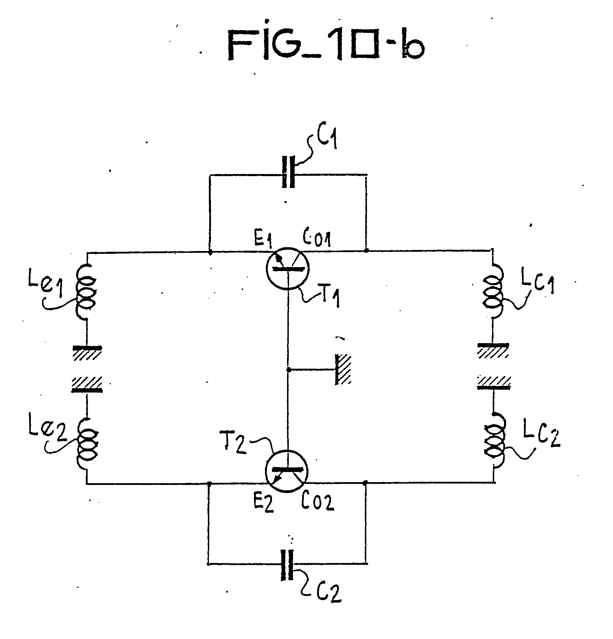

La figure 10a représente un amplificateur comportant au moins deux transistors $T_1$ et $T_2$ montés en push-pull. Généralement, ces deux transistors ne sont pas débloqués au même instant. Le montage proposé selon l'invention consiste à connecter une capacité respectivement $C_1$ et $C_2$ entre l'émetteur d'un premier transistor $T_1$ respectivement $T_2$ et le collecteur du deuxième transistor $T_2$ respectivement $T_1$, permettant ainsi de débloquer le transistor le plus lent par le transistor le plus rapide.

La figure 10b représente une variante du montate de la capacité suivant l'invention, pour un amplificateur à deux transistors montés en push-pull. Les capacités $C_1$ et $C_2$ sont montés directement en parallèle sur les transistors $T_1$ et $T_2$ respectivement.

Dans l'exposé de l'invention, on a pris le cas d'un transistor monté en base commune. L'enseignement de l'invention est également obtenu avec un transistor monté en émetteur ou collecteur commun. La capacité C utilisée est du même type que celle décrite dans ce qui précède et doit avoir une très faible constante de temps, et sa valeur est du même ordre de grandeur que celle décrite. Elle ne doit pas être chimique. Suivant le montage du transistor en émetteur ou collecteur commun, cette capacité est connectée entre base et collecteur ou base et émetteur.

Le montage décrit est toutefois un montage préférentiel car les transistors à grande puissance sont prévus pour être utilisés avec la base à la masse, les capacités internes du transistor étant alors plus faibles.

On a ainsi décrit un amplificateur à transistor, fonctionnant en hyperfréquence en régime impulsionnel.

## Revendications

1. Amplificateur à transistor fonctionnant en hyperfréquence en régime impulsionnel comportant:
— au moins un transistor (T) monté en base à la masse et recevant des impulsions dites d'entrée,
— une self ($L_e$) dite d'entrée placée en parallèle sur la base du transistor (T),
— une source de tension d'alimentation ($V_{cc}$) appliquant un courant ($I_c$) au collecteur du transistor (T) à travers une self ($L_c$) dite de collecteur,
— une capacité ($C_4$) connectée en parallèle sur la source ($V_{cc}$),
— une capacité ($C_3$) de découplage connectée entre la source ($V_{cc}$) et la self de collecteur ($L_c$), caractérisé en ce qu'il comporte de plus une capacité (C) connectée entre l'émetteur (E) et le collecteur ($C_o$) du transistor (T), chargée par la source de tension d'alimentation ($V_{cc}$) et destinée à emmagasiner de l'énergie pendant les périodes de repos du transistor (T) et à la restituer au début de chaque impulsion d'entrée avec une constante de temps la plus réduite possible.

2. Amplificateur selon la revendication 1, comportant au moins deux transistors ($T_1$ et $T_2$) montés en push-pull, caractérisé en ce qu'il comporte au moins deux capacités ($C_1$ et $C_2$) connectées chacune entre l'émetteur d'un transistor ($T_1$) respecti-

vement ($T_2$) et le collecteur de l'autre transistor ($T_2$) respectivement ($T_1$).

3. Amplificateur selon la revendication 1, comportant au moins deux transistors ($T_1$ et $T_2$) montés en push-pull, caractérisé en ce qu'il comporte au moins deux capacités ($C_1$ et $C_2$) connectées chacune entre l'émetteur et le collecteur d'un transistor ($T_1$) respectivement ($T_2$).

4. Amplificateur selon la revendication 1, dans lequel le transistor (T) est monté soit en émetteur commun, soit en collecteur commun, caractérisé en ce que la capacité (C) est montée soit entre le collecteur et la base, soit entre l'émetteur et la base du transistor (T).

5. Amplificateur selon l'une des revendications précédentes, caractérisé en ce que la capacité (C) a une valeur comprise entre 0,1 et 5 microfarads.


**Patentansprüche**

1. Transistorverstärker für den Mikrowellenbereich und Impulsbetrieb mit
— mindestens einem Transistor (T), dessen Basis an Masse liegt und der Eingangsimpulse zugeführt erhält,
— einer Eingangsspule ($L_e$), die parallel zur Emitterbasisstrecke des Transistors (T) liegt,
— einer Versorgungsspannungsquelle ($V_{cc}$), die einen Strom ($I_c$) an den Kollektor des Transistors (T) über eine Kollektorspule ($L_c$) anlegt,
— einem Kondensator ($C_4$), der parallel zur Quelle ($V_{cc}$) liegt,
— einem Entkopplungskondensator ($C_3$), der zwischen der Quelle ($V_{cc}$) und der Kollektorspule ($L_c$) liegt,
dadurch gekennzeichnet, dass er ausserdem einen Kondensator (C) enthält, der zwischen den Emitter (E) und den Kollektor ($C_o$) des Transistors (T) eingefügt ist, von der Versorgungsspannungsquelle ($V_{cc}$) geladen wird und dazu besimmt ist, Energie während der Ruheperioden des Transistors (T) zu speichern und diese Energie zu Beginn jedes Eingangsimpulses mit einer möglichst kurzen Zeitkonstante wieder abzugeben.

2. Verstärker nach Anspruch 1, mit mindestens zwei Transistoren ($T_1$ und $T_2$) in Gegentaktschaltung, dadurch gekennzeichnet, dass er mindestens zwei Kondensatoren ($C_1$ und $C_2$) aufweist, die je zwischen den Emitter einer der Transistoren ($T_1$ und $T_2$) und den Kollektor des anderen Transistors ($T_2$ bzw. $T_1$) angeschlossen ist.

3. Verstärker nach Anspruch 1, mit mindestens zwei Transistoren ($T_1$ und $T_2$) in Gegentaktschaltung, dadurch gekennzeichnet, dass er mindestens zwei Kondensatoren ($C_1$ und $C_2$) aufweist, die je zwischen dem Emitter und dem Kollektor eines der beiden Transistoren ($T_1$ bzw. $T_2$) angeschlossen sind.

4. Verstärker nach Anspruch 1, in dem der Transistor (T) entweder in Emitterbasis- oder in Kollektorbasisschaltung angeordnet ist, dadurch gekennzeichnet, dass der Kondensator (C) entweder zwischen dem Kollektor und der Basis oder zwischen dem Emitter und der Basis des Transistors (T) eingefügt ist.

5. Verstärker nach einem der vorhergehenden Ansprüche, dadurch gekennzeichnet, dass der Kondensator (C) eine Kapazität zwischen 0,1 und 5 μF besitzt.


**Claims**

1. A transistor amplifier operating at microwave frequencies under pulse operating conditions and comprising:
— at least one transistor (T) connected with base to ground and receiving input pulses,
— an input inductance ($L_e$) placed in parallel to the emitterbase transition of the transistor (T),
— a voltage supply source ($V_{cc}$) delivering a current ($I_c$) to the collector of the transistor (T) via a collector inductance ($L_c$),
— a capacitor ($C_4$) connected parallel to the source ($V_{cc}$),
— a decoupling capacitor ($C_3$) inserted between the source ($V_{cc}$) and the collector inductance ($L_c$),
characterized in that it further comprises a capacitor (C) which is connected between the emitter (E) and the collector ($C_o$) of the transistor (T), this capacitor being charged by the supply voltage source ($V_{cc}$) and conceived to store energy during the rest period of the transistor (T) and to restitute it at the beginning of each input pulse with the lowest possible time constant.

2. An amplifier according to claim 1, comprising at least two transistors ($T_1$ and $T_2$) mounted in a push-pull configuration, characterized in that it comprises at least two capacitors ($C_1$ and $C_2$), each connected between the emitter of one of the transistors ($T_1$ and $T_2$ respectively) and the collector of the other transistor ($T_2$ and $T_1$ respectively).

3. An amplifier according to claim 1, comprising at least two transistors ($T_1$ and $T_2$) mounted in a push-pull configuration, characterized in that it comprises at least two capacitors ($C_1$ and $C_2$), each connected between the emitter and the collector of one of the transistors $T_1$ and $T_2$ respectively).

4. An amplifier according to claim 1, in which the transistor (T) is mounted either in a common emitter configuration or in a common collector configuration, characterized in that the capacitor (C) is mounted either between the collector and the base or between the emitter and the base of the transistor (T).

5. An amplifier according to one of the preceding claims, characterized in that the capacitor (C) has a capacity value between 0.1 and 5 μF.

# FIG_1

# FIG_2

# FIG_3

0 079 352

FIG_4

(a) $S_{11}$

(b) $S_{12}$

(c) $S_{21}$

(d) $S_{22}$

FIG_5

(a)

(b)

9

# FIG_6

0 079 352

FIG_7

(a) (b)

(c) (d)

FIG_8

13

# FIG_9

# FIG_10-a

# FIG_10-b